# EUROPÄISCHE PATENTSCHRIFT

(11) **EP 0 668 540 B1**
(45) Veröffentlichungstag und Bekanntmachung des Hinweises auf die Patenterteilung: **10.05.2000**
(21) Anmeldenummer: 95100490.2
(22) Anmeldetag: 16.01.1995
(51) Int. Cl.: G03F 7/022

(54) **Positiv arbeitendes Aufzeichnungsmaterial mit verbesserter Entwickelbarkeit**
Positive working recording material with improved development properties
Matériel d'enregistrement en positif ayant un développement amélioré

(30) Priorität: 24.01.1994 DE 4401940
(43) Veröffentlichungstag der Anmeldung: 23.08.1995
(73) Patentinhaber: Agfa-Gevaert AG, 51373 Leverkusen (DE)
(72) Erfinder: Elsässer, Andreas, Dr., D-65510 Idstein (DE); Buhr, Gerhard, Dr., D-61462 Königstein (DE)

(56) Entgegenhaltungen:
- EP-A- 0 096 282
- EP-A- 0 301 332
- EP-A- 0 384 481
- EP-A- 0 488 713
- EP-A- 0 496 640
- EP-A- 0 510 983
- EP-A- 0 541 905
- EP-A- 0 573 056
- DE-A- 3 727 848
- DE-A- 4 335 425
- US-A- 4 871 645
- US-A- 5 089 373
- DATABASE WPI Week 9318, Derwent Publications Ltd., London, GB; AN 93-148404 & JP 5 083 836 A (HITACHI)

## Beschreibung

Die Erfindung betrifft ein positiv arbeitendes Aufzeichnungsmaterial mit einem Aluminiumträger und einer strahlungsempfindlichen Schicht, die ein 1,2-Naphthochinon-2-diazid als strahlungsempfindliche Verbindung und einen Novolak als Bindemittel enthält. Durch bildmäßiges Bestrahlen und nachfolgendes Entwickeln läßt sich daraus eine positiv arbeitende Flachdruckplatte herstellen.

Solche Aufzeichnungsmaterialien sind grundsätzlich bekannt. So ist in der DE-A 25 47 905 (= GB-A 1 561 438) ein strahlungsempfindliches Aufzeichnungsmaterial mit einem Aluminiumträger und einer strahlungsempfindlichen Schicht offenbart, die als lichtempfindliche Verbindung ein 1,2-Chinondiazid-sulfonsäure-ester oder -amid und ein Novolak als Bindemittel enthält. Die Schicht enthält darüber hinaus noch eine Verbindung, die eine aromatische oder aliphatische, vorzugsweise phenolische oder enolische Hydroxygruppe aufweist und die Chelatkomplexe bilden kann. Diese Verbindung ist insbesondere 2,3,4-Trihydroxy-benzophenon.

Positiv arbeitende strahlungsempfindliche Gemische und damit hergestellte Aufzeichnungsmaterialien sind bereits bekannt. So ist in der EP-A 0 435 181 ein positiv arbeitendes Photoresistgemisch mit einem 1,2-Chinondiazid und einem alkalilösliches Harz, gewonnen durch Kondensation eines m-Cresol/2-tert.-Butyl-5-methyl-phenol-Gemisches mit einem Aldehyd, beschrieben. Das Gemisch kann daneben auch ein 1,1,1-Tris-hydroxyphenyl-(C₁-C₄)alkan enthalten, wobei die Hydroxyphenylreste noch mit (C₁-C₅)Alkyl- oder (C₁-C₅)Alkoxyresten substituiert sein können. Eine konkret offenbarte Verbindung dieses Typs ist Bis-(4-hydroxy-2,5-dimethyl-phenyl)-(2-hydroxy-phenyl)-methan.

Das Photoresistgemisch gemäß der EP-A 0 415 266 unterscheidet sich von dem vorgenannten allein durch die Wahl des alkalilöslichen Bindemittels, das in diesem Fall durch Kondensation eines m-Cresol/2,3,5-Trimethyl-phenol-Gemisches mit einem Aldehyd erhältlich ist.

Ein positiv arbeitendes lichtempfindliches Gemisch, das einen Ester oder ein Amid einer 1,2-Napthochinondiazidsulfon- oder -carbonsäure als lichtempfindliche Verbindung, ein in wäßrig-alkalischen Lösungen lösliches, wasserunlösliches Phenolharz als Bindemittel und zusätzlich eine die Empfindlichkeit steigernde Bis-(4-hydroxyphenyl)-Verbindung enthält, ist in der DE-A 37 18 416 (= US-A 5 225 310) beschrieben.

Vor dem Aufbringen der strahlungsempfindlichen Schicht wird das Aluminiumträgermaterial üblicherweise mechanisch und/oder elektrochemisch aufgerauht, anodisch oxidiert (eloxiert) und hydrophiliert. Die strahlungsempfindliche Schicht weist gewöhnlich ein Gewicht von weniger als 3 g pro Quadratmeter auf. Das Aufzeichnungsmaterial wird durch eine Filmvorlage hindurch bildmäßig bestrahlt. Dazu benutzt man üblicherweise einen Vakuum-Kontaktkopierrahmen. Das bildmäßig bestrahlte Material wird dann mit einer wäßrig-alkalischen Lösung entwickelt. Soll die Flachdruckplatte danach nicht unmittelbar zum Drucken eingesetzt werden, so kann sie mit einer hydrophilen Konservierung versehen werden.

Übliche Entwickler für Positiv-Druckplatten weisen einen Gehalt an Alkali von 0,8 bis 0,9 mol/l auf. Wird die Entwicklung manuell durchgeführt, so dauert sie in der Regel etwa eine Minute. Für einen Quadratmeter des bestrahlten Aufzeichnungsmaterials werden dabei etwa 150 ml Entwickler benötigt. Bei der maschinellen Entwicklung mit der Standard-Verarbeitungsgeschwindigkeit von 0,8 m/min kommt das Aufzeichnungsmaterial nur etwa 20 bis 30 s mit dem Entwickler in Berührung. Diese Zeitspanne liegt nur geringfügig über der Mindestentwicklungszeit. Aufzeichnungsmaterial und Entwickler müssen gut aufeinander abgestimmt sein, um in dieser kurzen Zeit eine vollständige Entwicklung zu gewährleisten. Die während der Entwicklung abgelösten Schichtbestandteile bewirken eine Abnahme des Alkaligehalts im Entwickler. Dies wird gewöhnlich durch Zugabe einer entsprechenden Menge eines alkalischen Regenerats ausgeglichen. Allgemein werden bei maschineller Entwicklung etwa 100 ml Entwicklerlösung pro Quadratmeter Aufzeichnungsmaterial benötigt. Die bisher allgemein verwendeten Entwickler gefährden jedoch durch ihren relativ hohen Gehalt an Alkali die Gesundheit des Anwenders. Auch ist die Beseitigung der gebrauchten Entwickler problematisch.

Es war daher wünschenswert, den Alkaligehalt auf weniger als 0,6 mol/l zu reduzieren. Bei Verwendung von solchen schwach alkalischen Entwicklern mußten jedoch bisher deutlich längere Entwicklungszeiten in Kauf genommen werden. Bei maschineller Entwicklung ging die Verarbeitungsgeschwindigkeit um etwa die Hälfte zurück. Auch wurde dabei mit 200 ml/m² und mehr selbst bei kontinuierlicher Regenerierung eine deutlich größere Entwicklermenge benötigt.

Es bestand somit die Aufgabe, ein positiv arbeitendes Aufzeichnungsmaterial zur Verfügung zu stellen, das mit einem schwach alkalischen Entwickler (weniger als 0,6 mol/l an Alkali) entwickelt werden kann, ohne die Entwicklungsdauer zu verlängern oder die Entwicklermenge im Verhältnis zur Leistung zu erhöhen. Dabei sollten die Empfindlichkeit des Aufzeichnungsmaterials beim bildmäßigen Bestrahlen nicht verringert, die Stabilität der unbestrahlten Bereiche der Schicht gegen den Entwickler nicht vermindert und die Druckauflage sowie das Einbrennverhalten der daraus hergestellten Flachdruckplatten nicht negativ beeinflußt werden.

Gelöst wird die Aufgabe durch ein positiv arbeitendes Aufzeichnungsmaterial mit einem Aluminiumträger und einer mattierten strahlungsempfindlichen Schicht, die ein 1,2-Naphthochinon-2-diazid als strahlungsempfindliche Verbindung und ein in Wasser unlösliches, in wäßrigem Alkali dagegen lösliches oder quellbares Bindemittel enthält, dadurch gekennzeichnet, daß
- das strahlungsempfindliche 1,2-Naphthochinon-2-diazid ein Ester aus 1,2-Naphthochinon-2-diazid-4- oder -5-sulfonsäure und einer phenolischen Verbindung mit mindestens 2, bevorzugt mindestens 3, phenolischen Hydroxygruppen ist, der einen Gehalt an phenolischen Hydroxygruppen von mindestens 0,5 mmol/g und einen Gehalt an Diazoeinheiten von mindestens 1,5 mmol/g hat,
- das Bindemittel ein Phenol/Formaldehyd-Novolak mit mindestens 5 mmol/g an phenolischen Hydroxygruppen ist, dessen Phenolkomponente mindestens 30 mol-% m-Cresol und mindestens 10 mol-% mindestens eines Xylenols enthält, und ein Gewichtsmittel M_{w} von 2.000 bis 12.000 hat (bestimmt mittels GPC mit Polystyrol als Standard) und
- die strahlungsempfindliche Schicht zusätzlich mindestens ein phenolisches Additiv enthält, das ein Molekulargewicht M_{w} von maximal 600 sowie 2 bis 4 nicht-kondensierte Phenylkerne und mindestens 6 mmol/g an phenolischen Hydroxygruppen aufweist.

Das phenolische Additiv ist vorzugsweise eine Verbindung der Formeln I bis III 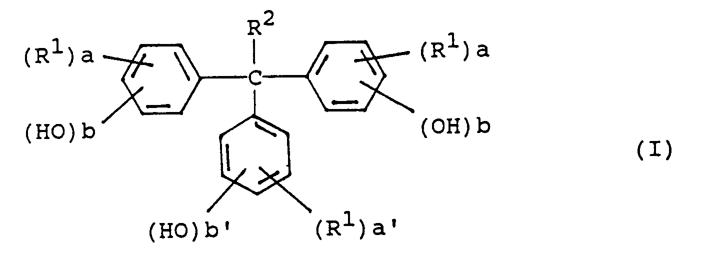 worin
- R¹: eine (C₁-C₄)Alkyl-, Methoxy- oder Ethoxygruppe,
- R²: ein Wasserstoffatom oder eine Methylgruppe ist,
- a,a': unabhängig voneinander 0, 1 oder 2, und
- b,b': unabhängig voneinander 1, 2 oder 3 sind; 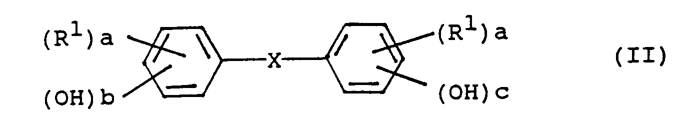
worin
- X: für eine Einfachbindung, SO₂, S, O oder CO
- R¹, a,b: die oben angegebene Bedeutung haben und
- c: eine ganze Zahl von 0 bis 3 ist; 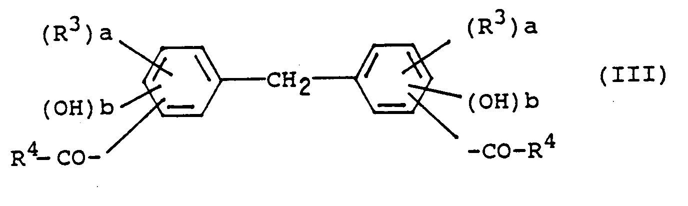
worin
- R³: eine (C₁-C₄)Alkylgruppe,
- R⁴: ein Wasserstoffatom, eine (C₁-C₄)Alkyl- oder Phenylgruppe und
- a, b: die oben angegebene Bedeutung haben.

In den Verbindungen der Formel I ist R¹ bevorzugt eine Methylgruppe, a' ist bevorzugt 0 und b und b' sind bevorzugt 1. Besonders bevorzugt sind Verbindungen, in denen darüber hinaus R² ein Wasserstoffatom und a = 2 ist.

Von den Verbindungen der Formel III sind die bevorzugt, in denen R⁴ ein Wasserstoffatom oder eine Methylgruppe, a = 0 oder 1 und b = 2 oder 3 ist. Besonders bevorzugt sind phenolische Additive mit einem Hydroxygruppengehalt von 7 bis 19 mmol/g. Die phenolischen Additive, insbesondere die phenolischen Verbindungen der Formeln I bis III, bewirken in überraschender Weise eine schnellere und effektivere Entwicklung in den genannten schwach alkalischen Entwicklern.

Der Anteil der Additive beträgt etwa 1 bis 20 Gew.-%, bevorzugt 2 bis 10 Gew.-%, jeweils bezogen auf das Gesamtgewicht der nichtflüchtigen Bestandteile der strahlungsempfindlichen Schicht.

Der Anteil des Novolak-Bindemittels beträgt 40 bis 90 Gew.-%, bevorzugt 60 bis 85 Gew.-%, jeweils bezogen auf das Gesamtgewicht der nichtflüchtigen Bestandteile der strahlungsempfindlichen Schicht. Der Hydroxygruppengehalt des Bindemittels liegt bevorzugt bei mindestens 7,0 mmol/g. Die damit hergestellte Druckplatten erzielen hohe Druckauflagen.

Besonders geeignete strahlungsempfindliche Verbindungen sind Ester aus 1,2-Naphthochinon-2-diazid-4- oder -5-sulfonsäure und Trihydroxybenzolen oder davon abgeleiteten Verbindungen, wie 1,2,3-Trihydroxy-benzol (= Pyrogallol) oder 2,3,4-Trihydroxy-acetophenon (= Gallacetophenon). Es sind jedoch nicht alle Hydroxygruppen verestert, um den oben angegebenen Mindestanteil an freien Hydroxygruppen nicht zu unterschreiten. Besonders geeignet sind Ester aus 2,3,4,2',3',4'-Hexahydroxy-5,5'-dibenzoyl-diphenylmethan oder 5,5'-Diacetyl-2,3,4,2',3',4'-hexahydroxy-diphenylmethan, in denen von den jeweils 6 Hydroxygruppen im Durchschnitt 2,5 bis 4,5 mit 1,2-Naphthochinon-2-diazid-4- oder -5-sulfonsäure verestert sind. Besonders bevorzugt sind Verbindungen mit einem Hydroxygruppengehalt von ≥ 1 mmol/g und einem Diazogruppengehalt von ≥ 2 mmol/g.

Der Anteil der strahlungsempfindlichen Verbindungen beträgt 5 bis 50 Gew.-%, bevorzugt 10 bis 30 Gew.-%, jeweils bezogen auf das Gesamtgewicht der nichtflüchtigen Bestandteile der strahlungsempfindlichen Schicht.

Die strahlungsempfindliche Schicht enthält vorteilhaft noch einen Indikatorfarbstoff. Dies ist bevorzugt ein kationischer Triarylmethan- oder Methinfarbstoff. Der Anteil des Farbstoffs beträgt 0,1 bis 5 Gew.-%, bevorzugt 0,5 bis 3 Gew.-%, jeweils bezogen auf das Gesamtgewicht der nichtflüchtigen Bestandteile der strahlungsempfindlichen Schicht. Darüber hinaus kann die strahlungsempfindliche Schicht noch weitere übliche Zusätze enthalten. Hierzu zählen insbesondere Belichtungskontrastverstärker.

Das erfindungsgemäße Aufzeichnungsmaterial ist mattiert, d.h. es hat eine rauhe Oberfläche. Dazu werden allgemein Mattierungsmittel einer bestimmten Partikelgröße verwendet. Sie können in die Kopierschicht eingearbeitet oder auf die Kopierschicht aufgebracht sein. Es kommen organische und anorganische Mattierungsmittel in Frage. Die zur Mattierung verwendeten Partikel können auch die gleiche Zusammensetzung haben wie die strahlungsempfindliche Schicht. Die mittlere Höhe der Erhebungen auf der Kopierschicht beträgt vorteilhaft 0,5 bis 8 µm. Auf jedem Quadratzentimeter der Aufzeichnungsschicht befinden sich durchschnittlich 100 bis 10.000 dieser Partikel. Nähere Angaben zu einer besonders geeigneten Mattierung finden sich in der nicht vorveröffentlichten DE-A 43 35 425. Durch die Mattierung ist sichergestellt, daß im Vakuum-Kontaktkopierrahmen die Luft zwischen Filmvorlage und Aufzeichnungsmaterial in kurzer Zeit restlos abgepumpt werden kann.

Zur bildmäßigen Bestrahlung werden die zur Herstellung von Flachdruckplatten allgemein üblichen und dem Fachmann bekannten Strahlungsquellen verwendet.

Bei der nachfolgenden Entwicklung wird vorzugsweise ein wäßrig-alkalischer Entwickler auf Silikat-Basis verwendet. Das Verhältnis von SiO₂ zu Alkalioxid sollte mindestens 1:1 betragen. Damit ist sichergestellt, daß die Eloxalschicht des Trägermaterials beim Entwickeln nicht angegriffen wird. Bevorzugte Alkalioxide sind Na₂O und K₂O sowie Gemische davon. Neben Alkalisilikaten kann der Entwickler weitere Bestandteile, wie Puffersubstanzen, Komplexbildner, Entschäumer, Lösemittel, Korrosionsinhibitoren, Farbstoffe, insbesondere auch Tenside und/oder Hydrotrope enthalten. Die Entwicklung wird vorzugsweise bei Temperaturen von 20 bis 30 °C durchgeführt. Bei Verwendung von automatischen Entwicklungsgeräten lassen sich die erfindungsgemäßen Aufzeichnungsmaterialien mit einer Geschwindigkeit von 0,8 m/min und mehr entwickeln.

Zur Regenerierung des Entwicklers werden vorteilhaft Alkalisilikatlösungen mit Alkaligehalten von 0,6 bis 2,0 mol/l verwendet. Sie können das gleiche oder ein anderes Siliciumdioxid/Alkalioxid-Verhältnis aufweisen wie der Entwickler selbst. Allgemein ist dieses Verhältnis jedoch niedriger als in dem Entwickler. Die jeweils zugegebene Menge an Regenerat muß auf die Entwicklungsgeräte, die Anzahl der pro Tag zu verarbeitenden Platten, die durchschnittlichen Bildanteile auf diesen Platten und die anderen individuelle Faktoren abgestimmt sein. Allgemein werden 1 bis 50 ml Regenerat pro Quadratmeter Aufzeichnungsmaterial zugesetzt. Die benötigte Menge an Regenerat kann beispielsweise durch Leitwertmessung ermittelt werden.

Die nachfolgenden Beispiele dienen zur Erläuterung des Gegenstands der Erfindung. Vergleichsbeispiele und Vergleichssubstanzen sind mit * gekennzeichnet. Gt steht für Gewichtsteile.

Verwendete Abkürzungen in alphabetischer Reihenfolge:
- B: = Belichtungskontrastverstärker
- D: = Diazoeinheit
- E: = entwicklungsfördernde Additive
- EG: = Entwicklungsgeschwindigkeit
- ER: = Entwicklerresistenz
- EV: = Entwicklerverbrauch
- GAG: = Gesamtalkaligehalt
- I: = Indikatorfarbstoff
- LE: = Lichtempfindlichkeit
- N: = Novolak
- PGG: = Phenolgruppengehalt

Die folgenden 1,2-Chinondiazide wurden in der strahlungsempfindlichen Schicht des Aufzeichnungsmaterials verwendet:
- D1: Ester aus 1 mol 2,3,4-Trihydroxy-benzophenon und 1,5 mol 1,2-Naphthochinon-2-diazid-5-sulfonylchlorid (der Ester enthielt jeweils 2,6 mmol/g an phenolischen Hydroxygruppen und an Diazoeinheiten);
- D2*: Ester aus 1 mol 2,3,4-Trihydroxy-benzophenon und 3,0 mol 1,2-Naphthochinon-2-diazid-5-sulfonylchlorid (der Ester enthielt keine phenolischen Hydroxygruppen; 3,24 mmol/g an Diazoeinheiten);
- D3: Ester aus 1 mol 2,3,4-Trihydroxy-benzophenon und 1,1 mol 1,2-Naphthochinon-2-diazid-4-sulfonylchlorid (3,9 mmol/g an phenolischen Hydroxygruppen, 2,3 mmol/g an Diazoeinheiten);
- D4: Ester aus 1 mol 5,5'-Dibenzoyl-2,3,4,2',3',4'-hexahydroxy-diphenylmethan und 3,5 mol 1,2-Naphthochinon-2-diazid-5-sulfonylchlorid (2,0 mmol/g an phenolischen Hydroxygruppen; 2,7 mmol/g an Diazoeinheiten);
- D5: Ester aus 1 mol 5,5'-Diacetyl-2,3,4,2',3',4'-hexahydroxy-diphenylmethan und 4,5 mol 1,2-Naphthochinon-2-diazid-5-sulfonylchlorid (1,1 mmol/g an phenolischen Hydroxygruppen; 3,2 mmol/g an Diazoeinheiten);
- D6: Ester aus 1 mol 5,5'-Dibenzoyl-2,3,4,2',3',4'-hexahydroxy-diphenylmethan und 3,5 mol 1,2-Naphthochinon-2-diazid-4-sulfonylchlorid (2,0 mmol/g an phenolischen Hydroxygruppen; 2,7 mmol/g an Diazoeinheiten);
- D7*: Ester aus 1 mol 5,5'-Dibenzoyl-2,3,4,2',3',4'-hexahydroxy-diphenylmethan und 6,0 mol 1,2-Naphthochinon-2-diazid-5-sulfonylchlorid (der Ester enthielt keine phenolischen Hydroxygruppen; 2,7 mmol/g an Diazoeinheiten).

Als Bindemittel in der strahlungsempfindlichen Schicht wurden die folgenden Novolake verwendet (das mittlere Molekulargewicht M_{w} wurde durch GPC mit Polystyrol als Standard bestimmt):
- N1: Novolak aus 30 mol-% 3,5-Xylenol und 70 mol-% m-Cresol (M_{w}: 3.000; 8,05 mmol/g an phenolischen Hydroxygruppen);
- N2: Novolak aus 20 mol-% 2,4-/2,5-Xylenolgemisch, 40 mol-% m-Cresol und 40 mol-% p-Cresol (M_{w}: 8.000; 8,15 mmol/g an phenolischen Hydroxygruppen);
- N3*: Novolak aus 25 mol-% 4-tert.-Butyl-phenol und 75 mol-% Phenol (M_{w}: 8.500; 8,33 mmol/g an phenolischen Hydroxygruppen);
- N4: Novolak aus 10 mol-% 3,5-Xylenol und 90 mol-% m-Cresol (M_{w}: 3.000; 8,24 mmol/g an phenolischen Hydroxygruppen);
- N5*: Novolak aus 20 mol-% 2,4-/2,5-Xylenolgemisch, 40 mol-% m-Cresol und 40 mol-% p-Cresol (M_{w}: 13.000; 8,15 mmol/g an phenolischen Hydroxygruppen).

Als Indikatorfarbstoffe wurden verwendet:
- I1: Kristallviolett (C.I. 42.555)
- I2: Viktoria-Reinblau (C.I. 44.045)

Als entwicklungsfördernde Additive wurden verwendet (PGG = Phenolgruppengehalt in mmol/g):
- E1: 4,4',4''-Trihydroxy-triphenylmethan (Formel I, R² = H; a = a' = 0; b = b' = 1) PGG: 10,3;
- E2: 1,1,1-Tris-(4-hydroxy-phenyl)-ethan (Formel I, R² = CH₃; a = a' = 0; b = b'= 1) PGG: 9,8;
- E3: 4,4',2''-Trihydroxy-2,5,2',5'-tetramethyl-triphenylmethan (Formel I, R² = H; a = 2; a' = 0; b = b' = 1) PGG: 8,6;
- E4: 4,4',4''-Trihydroxy-2,5,2',5'-tetramethyl-triphenylmethan (Formel I, R² = H; a = 2; a' = 0; b = b' = 1) PGG: 8,6;
- E5: 2,3,4,4'-Tetrahydroxy-benzophenon (Formel II, X = CO; a = 0; b = 3; c = 1) PPG: 16,0;
- E6: 4,4'-Dihydroxy-diphenylsulfon (Formel II, X = SO₂; a = 0; b = c = 1) PPG: 9,2;
- E7: 4,4'-Dihydroxy-3,5,3',5'-tetramethyl-diphenylsulfon (Formel II, X = SO₂; R¹ = CH₃; a = 0; b = c = 1) PPG: 7,3;
- E8: 2,4-Dihydroxy-benzophenon (Formel II, X = CO; a = c = 0; b = 2) PPG: 9,3;
- E9: 2,3,4-Trihydroxy-benzophenon (Formel II, X = CO; a = c = 0; b = 3) PPG: 13,0;
- E10: 5,5'-Diformyl-2,3,4,2',3',4'-hexahydroxy-diphenylmethan (Formel III, R⁴ = H; a = 0; b = 3) PPG: 18,7;
- E11: 5,5'-Diacetyl-2,3,4,2',3',4'-hexahydroxy-diphenylmethan (Formel III, R⁴ = CH₃; a = 0; b = 3) PPG: 17,2;
- E12: 5,5'-Diacetyl-2,4,2',4'-tetrahydroxy-3,3'-dimethyldiphenylmethan (Formel III, R³ = CH₃; R⁴ = H; a = 1; b = 2) PPG: 11,5;
- E13*: 2-Hydroxy-5,4'-diphenyl-benzophenon (Formel II, X = CO, R¹ = C₆H₅; a = b = 1; c = 0) PPG: 2,86.

Als Belichtungskontrastverstärker wurden verwendet:
- B1: 1,2-Naphthochinon-2-diazid-4-sulfonylchlorid;
- B2: 2-(4-Styryl-phenyl)-4,6-bis-trichlormethyl-s-triazin;
- B3: 4-Dimethylamino-azobenzol.

### Beispiel 1

Eine 0,3 mm starke Aluminiumfolie wurde in Salzsäure elektrolytisch aufgerauht (R_{z}-Wert nach DIN 4768: 5,0 µm), in Schwefelsäure zwischengebeizt, dann in Schwefelsäure anodisch oxidiert (Oxidgewicht 4,0 g/m²), mit Polyvinylphosphonsäure hydrophiliert und anschließend mit einer Lösung beschichtet, die
- 73,0 Gew.-%: N2,
- 18,0 Gew.-%: D entsprechend der oben angegebenen Aufstellung,
- 2,5 Gew.-%: B1,
- 1,3 Gew.-%: I2,
- 4,0 Gew.-%: E3,
- 1,0 Gew.-%: Mattierungsmittel (Kieselsäure mit einer mittleren Korngröße von 4 µm) und
- 0,2 Gew.-%: eines Tensids mit Dimethylsiloxan- und Ethylenoxid-Einheiten in Butanon/Propylenglykol-monomethylether (40 Gt/60 Gt)
enthielt. Der Anteil der nichtflüchtigen Bestandteile in der Beschichtungslösung lag bei 13 Gew.-%. Nach 1 min Trocknen bei 125 °C betrug das Gewicht der strahlungsempfindlichen Schicht 2,4 g/m².

Das so hergestellte strahlungsempfindliche Aufzeichnungsmaterial wurde dann in einem Vakuum-Kontaktkopierrahmen durch einen UGRA-Offset-Testkeil mit Hilfe einer im Abstand von 110 cm befindlichen 5 kW-Metallhalogenid-Quecksilberdampflampe bildmäßig bestrahlt. Anschließend wurde es in einem Tauchbadentwicklungsgerät, das einen Kaliumsilikat-Entwickler (Molverhältnis K₂O:Si₂O = 1:1; Gesamtalkaligehalt (GAG): 0,4 mol/l) enthielt, entwickelt. In den Vergleichsbeispielen wurde zusätzlich mit einer Lösung entwickelt, die einen Gesamtalkaligehalt von 0,9 mol/l aufwies (das K₂O:SiO₂-Verhältnis blieb unverändert).

Die Ergebnisse sind in der folgenden Tabelle 1 dargestellt. Darin bedeuten
- LE: Lichtempfindlichkeit; angegeben ist die für eine offene Stufe 5 im UGRA-Offset-Testkeil erforderliche Belichtungszeit (in Takten; ermittelt aus einem Belichtungsfächer) bei einer Verarbeitungsgeschwindigkeit von 0,4 m/min;
- EG: Entwicklungsgeschwindigkeit; die Geschwindigkeit, mit der die bildmäßig bestrahlten Aufzeichnungsmaterialien durch das Entwicklungsgerät laufen, wurde in Schritten von 0,1 m/min von 0,4 auf 1,4 m/min angehoben; es ist angegeben, bis zu welcher Geschwindigkeit (in m/min) eine vollständige Entwicklung möglich war;
- EV: Entwicklerverbrauch; bestimmt wurde das Volumen (in ml) an Entwickler, das bei Regenerierung pro Quadratmeter Aufzeichnungsmaterial notwendig war; Belichtungszeit und Entwicklungsgeschwindigkeit entsprachen den unter LE bzw. EG angegebenen Werten; das Regenerat wies dasselbe K₂O:SiO₂-Verhältnis auf wie der Entwickler selbst, hatte jedoch einen doppelt so hohen Gesamtalkaligehalt; regeneriert wurde mit 10 ml dieser Lösung pro Quadratmeter des bestrahlten Aufzeichnungsmaterials mit einem Bildanteil von 25%; die Erschöpfung des Entwicklers war an einer unvollständigen Entwicklung erkennbar, d.h. einem durch Reste der Schicht verursachten Schleier in den Nichtbildstellen. Der Test wurde abgebrochen und das Ergebnis als zufriedenstellend angesehen, wenn mehr als 10 m² des Aufzeichnungsmaterials mit 1 l Entwickler vollständig entwickelt werden konnten, ohne daß Restschichtschleier auftraten.

**Tabelle 1**

| Nr. | D | GAG | LE | EG | EV |
|---|---|---|---|---|---|
| 1-1 | D1 | 0,4 | 110 | 1,4 | <100 |
| 1-2* | D2* | 0,4 | 170 | 0,4 | 270 |
| 1-3* | D2* | 0,9 | 110 | 1,4 | <100 |
| 1-4 | D3 | 0,4 | 115 | 1,4 | <100 |
| 1-5 | D4 | 0,4 | 110 | 1,4 | <100 |
| 1-6 | D5 | 0,4 | 110 | 1,4 | <100 |
| 1-7 | D6 | 0,4 | 115 | 1,4 | <100 |
| 1-8* | D7* | 0,4 | 185 | 0,4 | 250 |
| 1-9* | D7* | 0,9 | 115 | 1,4 | <100 |

Die Ergebnisse zeigen, daß die erfindungsgemäßen Aufzeichnungsmaterialien eine ebenso hohe Lichtempfindlichkeit aufweisen, eine vergleichbar hohe Entwicklungsgeschwindigkeit zulassen und während des Entwickelns auch nicht mehr an Entwickler verbrauchen als bekannte Materialien, im Gegensatz zu diesen jedoch mit einem schwach alkalischen Entwickler entwickelt werden können.

An den Druckplatten gemäß den Beispielen 1-3*, 1-4, 1-5 und 1-9* wurden weitere Tests durchgeführt. Zunächst wurde geprüft, wie hoch die erreichbare Druckauflage in einer Bogenoffset-Druckmaschine ist. Dabei wurde mit einem Isopropanolgehalt im Feuchtwasser von 20 % gearbeitet. Dann wurde das Einbrennverhalten untersucht. Dazu wurde auf die entwickelten Platten eine handelsübliche Einbrenngummierung (z. B. ^{(R)}RC 514 der Hoechst AG) aufgetragen und in einem Durchlaufofen bei 250 °C und einer Durchlaufgeschwindigkeit von 0,8 m/min eingebrannt. Zeigte sich bei fünfminütiger Einwirkung von N-Methyl-pyrrolidon ein Angriff auf die Bildstellen, so war die thermische Härtung unvollständig (-), andernfalls wurde das Ergebnis mit (+) bezeichnet.

| Beispiel | Druckauflage | Einbrennverhalten |
|---|---|---|
| 1-3* | 110.000 | + |
| 1-4 | 110.000 | + |
| 1-5 | 110.000 | + |
| 1-9* | 110.000 | + |

Mit den erfindungsgemäßen Aufzeichnungsmaterialien lassen sich Druckplatten herstellen, die ein ebenso gutes Einbrennverhalten zeigen und eine ebenso hohe Druckauflage zulassen wie die mit bekannten Aufzeichnungsmaterialien hergestellten.

### Beispiel 2

Eine 0,3 mm starke Aluminiumfolie wurde in Salzsäure elektrolytisch aufgerauht (R_{z}-Wert nach DIN 4768: 3,2 µm), in Schwefelsäure zwischengebeizt, dann in Schwefelsäure anodisch oxidiert (Oxidgewicht 2,0 g/m²), mit Polyvinylphosphonsäure hydrophiliert und anschließend mit einer Lösung beschichtet, die
- 73,0 Gew.-%: Novolak entsprechend der oben angegebenen Aufstellung,
- 18,0 Gew.-%: D4,
- 2,5 Gew.-%: B1,
- 1,3 Gew.-%: I1,
- 4,0 Gew.-%: E7,
- 0,9 Gew.-%: Mattierungsmittel (Kieselsäure mit einer mittleren Korngröße von 4 µm) und
- 0,1 Gew.-%: ein Tensid mit Dimethylsiloxan- und Ethylenoxid-Einheiten in einem Gemisch aus Butanon/Propylenglykol-monomethylether (40 Gt/60 Gt)
enthielt. Der Anteil der nichtflüchtigen Bestandteile in der Beschichtungslösung lag bei 13 Gew.-%. Nach 1 min Trocknen bei 125 °C betrug das Gewicht der strahlungsempfindlichen Schicht 2,2 g/m².

Die Aufzeichnungsmaterialien wurden wie im Beispiel 1 beschrieben weiter verarbeitet.

Folgende Tests wurden durchgeführt:
- LE, EG, EV,: jeweils wie im Beispiel 1
- ER:: Die Flachdruckform wurde nach dem Entwickeln bei 0,4 m/min noch zweimal zusätzlich bei der gleichen Geschwindigkeit entwickelt und visuell auf Raster- und Volltonschäden untersucht (+ = keine Schädigung, - = Schädigung in Raster- und/oder Vollton, d.h. unzureichende Resistenz gegen den Entwickler).

**Tabelle 2**

| Nr. | N | GAG | LE | EG | EV | ER |
|---|---|---|---|---|---|---|
| 2-1 | N1 | 0,4 | 100 | 1,4 | <100 | + |
| 2-2 | N2 | 0,4 | 105 | 1,4 | <100 | + |
| 2-3* | N3* | 0,4 | 80 | 1,4 | <100 | - |
| 2-4 | N4 | 0,4 | 100 | 1,4 | <100 | + |
| 2-5* | N5* | 0,4 | 155 | 1,1 | 170 | + |

### Beispiel 3

Eine 0,4 mm starke Aluminiumfolie wurde wie in Beispiel 1 elektrolytisch aufgerauht, in Schwefelsäure zwischengebeizt und dann in Schwefelsäure anodisch oxidiert, mit Polyvinylphosphonsäure hydrophiliert und anschließend mit Lösungen gemäß Tabelle 3 beschichtet, denen jeweils 0,5 Gew.-% Mattierungsmittel (Kieselsäure mit einer mittleren Korngröße von 3 µm) und 0,2 Gew.-% eines Tensids mit Dimethylsiloxan- und Ethylen-/Propylenoxid-Einheiten hinzugefügt waren. Als Lösemittel wurde wieder ein Butanon/Propylenglykol-monomethylether-Gemisch (40 Gt/60 Gt) verwendet. Der Anteil der nichtflüchtigen Bestandteile in den Beschichtungslösungen betrug 13 Gew.-%.

**Tabelle 3**

| Nr. | N | D | I | B | E |
|---|---|---|---|---|---|
| | (Die Angaben in Klammern bedeuten jeweils Gew.-%) | | | | |
| 3-1 | 2 (82) | 3 (13,3) | 1 (1,5) | 2 (0,5) | 9 (2) |
| 3-2 | 2 (82) | 3 (13,3) | 2 (1,5) | 3 (0,5) | 9 (2) |
| 3-3 | 2 (82) | 6 (13,3) | 2 (1,5) | 3 (0,5) | 9 (2) |
| 3-4 | 2 (82) | 6 (13,3) | 1 (1,5) | 2 (0,5) | 9 (2) |

Nach 1 min Trocknen bei 125 °C betrug das Gewicht der strahlungsempfindlichen Schicht 1,8 g/m².

Für die Untersuchung des Entwicklerverbrauchs bei der Umkehrverarbeitung der Materialien wurde das Aufzeichnungsmaterial in einem Vakuumkopierrahmen durch Evakuieren mit einer Negativ-Testmontage kontaktiert und mit einer 5kW-Metallhalogenid-Quecksilberdampflampe bestrahlt. Dann wurde es in einem Durchlaufofen bei einer Verarbeitungsgeschwindigkeit von 0,8 m/min auf 135 °C erhitzt und nach Abkühlung in der ebenfalls integrierten Nachbelichtungseinheit vollflächig ausbelichtet. Entwickelt wurde dann in einem Tauchbadentwicklungsgerät mit einem Kaliumsilikat-Entwickler (Molverhältnis K₂O:Si₂O = 1:1), der 1 Gew.-% des Dikaliumsalzes von O,O'-Bis-carboxymethyl-polyethylenglykol-400 als Hydrotrop, 0,05 Gew.-% eines nichtionischen Tensids vom Typ der ethoxylierten/propoxylierten Ethylendiamine (Molekulargewicht 1600, 50 % Ethylenoxidgehalt) und einen GAG von 0,60 mol/l enthielt. Zur Regenerierung wurden einem Liter Entwickler 0,5 mol KOH zugefügt. Die Regeneratmenge betrug 10 ml/qm Flachdruckplatte mit einem Bildanteil von 25 %.

Bei den Versuchen 3-1 bis 3-4 traten bis zum Ende des Verbrauchstests (100 ml Entwickler/1 m² Aufzeichnungsmaterial) keine Restschichtschleier in den Nichtbildstellen auf.

### Beispiele 4

Eine 0,3 mm starke Aluminiumfolie wurde mit einer Bimsmehlsuspension gebürstet, in Salzsäure elektrolytisch aufgerauht (R_{z}-Wert nach DIN 4768: 6,0 µm), in Schwefelsäure zwischengebeizt, dann in Schwefelsäure eloxiert (Oxidgewicht 4,0 g/m²), mit Polyvinylphosphonsäure hydrophiliert und anschließend mit einer Lösung beschichtet, die
- Gew.-%: N1 (entsprechend Tabelle 4)
- 18,0 Gew.-%: D5,
- 1,0 Gew.-%: B1,
- 0,3 Gew.-%: B2,
- 1,7 Gew.-%: I1,
- Gew.-%: E (entsprechend Tabelle 4), in Butanon/Propylenglykol-monomethylether (40 Gt/60 Gt)
enthielt. Der Anteil der nichtflüchtigen Bestandteile in der Beschichtungslösung lag bei 13 Gew.-%. Nach 1 min Trocknen bei 125 °C betrug das Gewicht der strahlungsempfindlichen Schicht 2,4 g/m².

Mattiert wurde die Schicht mit einer 20%igen wäßrigen Lösung eines Terpolymeren aus Vinylsulfonsäure, Ethylacrylat und Styrol, die elektrostatisch so aufgesprüht wurde, daß die mittlere Höhe der Erhebungen 4 µm betrug.

Die Aufzeichnungsmaterialien wurden wie im Beispiel 1 belichtet, in einem Sprüh-/Staubad-Entwicklungsgerät mit einem Kaliumsilikat-Entwickler (Molverhältnis K₂O:Si₂O = 1:1,3), der 0,005 Gew.-% eines kationischen Tensids vom Typ der quaternären, ethoxylierten/propoxylierten Ammonium-Tenside und einen GAG von 0,45 mol/l enthielt.

Mit der ermittelten Belichtungszeit und bei einer Entwicklungsgeschwindigkeit von 0,8 m/min wurde ein Erschöpfungstest mit Regenerierung durchgeführt. Zur Regenerierung wurden einem Liter Entwickler 0,5 mol KOH zugefügt. Die Regeneratmenge betrug 20 ml/qm Flachdruckplatte mit einem Bildanteil von 25 %. Der Endpunkt des Tests machte sich in Form einer unvollständigen Entwicklung, d.h. eines durch Reste der Schicht verursachten Schleiers in den Nichtbildbereichen, bemerkbar.

**Tabelle 4**

| Beispiel | N1 Gew.-% | E in Gew.-% | | LE | EG | EV |
|---|---|---|---|---|---|---|
| 4-1* | 79 | - | - | 160 | 1,1 | 140 |
| 4-2 | 75 | 1 | 4 | 110 | 1,4 | <100 |
| 4-3 | 75 | 2 | 4 | 110 | 1,4 | <100 |
| 4-4 | 75 | 3 | 4 | 110 | 1,4 | <100 |
| 4-5 | 75 | 4 | 4 | 110 | 1,4 | <100 |
| 4-6 | 76 | 5 | 3 | 110 | 1,4 | <100 |
| 4-7 | 75 | 6 | 4 | 110 | 1,4 | <100 |
| 4-8 | 74 | 7 | 5 | 110 | 1,4 | <100 |
| 4-9 | 75 | 8 | 4 | 110 | 1,4 | <100 |
| 4-10 | 75 | 9 | 4 | 110 | 1,4 | <100 |
| 4-11 | 76 | 10 | 3 | 110 | 1,4 | <100 |
| 4-12 | 75 | 11 | 4 | 110 | 1,4 | <100 |
| 4-13 | 74 | 12 | 5 | 110 | 1,4 | <100 |
| 4-14* | 73 | 13 | 6 | 150 | 1,1 | 130 |

Die Ergebnisse zeigen, daß die erfindungsgemäßen Aufzeichnungsmaterialien eine ebenso hohe Lichtempfindlichkeit aufweisen, eine vergleichbar hohe Entwicklungsgeschwindigkeit zulassen und ebenso günstige Verbrauchswerte aufweisen wie bekannte Materialien (Beispiele 1-3*, 1-9*), im Gegensatz zu diesen jedoch mit einem schwach alkalischen Entwickler entwickelt werden können.

## Patentansprüche

1. Positiv arbeitendes Aufzeichnungsmaterial mit einem für Flachdruckplatten geeigneten Aluminiumträger und einer mattierten strahlungsempfindlichen Schicht, die ein 1,2-Naphthochinon-2-diazid als strahlungsempfindliche Verbindung und ein in Wasser unlösliches, in wäßrigem Alkali dagegen lösliches oder quellbares Bindemittel enthält, dadurch gekennzeichnet, daß
- das strahlungsempfindliche 1,2-Naphthochinon-2-diazid ein Ester aus 1,2-Naphthochinon-2-diazid-4- oder -5-sulfonsäure und einer phenolischen Verbindung mit mindestens 2 phenolischen Hydroxygruppen ist, der einen Gehalt an phenolischen Hydroxygruppen von mindestens 0,5 mmol/g und einen Gehalt an Diazoeinheiten von mindestens 1,5 mmol/g hat,
- das Bindemittel ein Phenol/Formaldehyd-Novolak mit mindestens 5 mmol/g an phenolischen Hydroxygruppen ist, dessen Phenolkomponente mindestens 30 mol-% m-Cresol und mindestens 10 mol-% mindestens eines Xylenols enthält, und ein Gewichtsmittel M_{w} von 2.000 bis 12.000 hat und
- die strahlungsempfindliche Schicht zusätzlich mindestens ein phenolisches Additiv enthält, das ein Molekulargewicht M_{w} von maximal 600 sowie 2 bis 4 nicht-kondensierte Phenylkerne und mindestens 6 mmol/g an phenolischen Hydroxygruppen aufweist.

2. Aufzeichnungsmaterial gemäß Anspruch 1, dadurch gekennzeichnet, daß das phenolische Additiv eine Verbindung der Formeln I bis III ist: 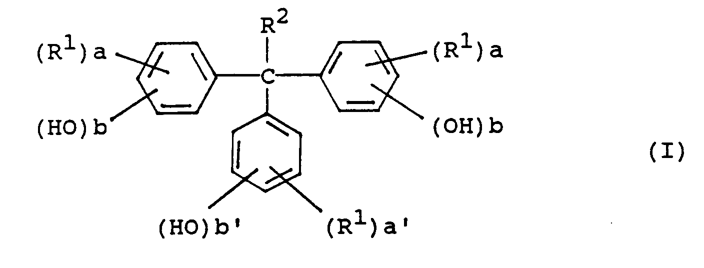 worin
R¹ eine (C₁-C₄)Alkyl-, Methoxy- oder Ethoxygruppe,
R² ein Wasserstoffatom oder eine Methylgruppe ist,
a,a' unabhängig voneinander 0, 1 oder 2, und
b,b' unabhängig voneinander 1, 2 oder 3 sind; 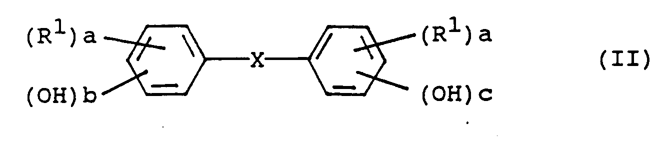
worin
X für eine Einfachbindung, SO₂, S, O oder CO
R¹, a,b die oben angegebene Bedeutung haben und
c eine ganze Zahl von 0 bis 3 ist; 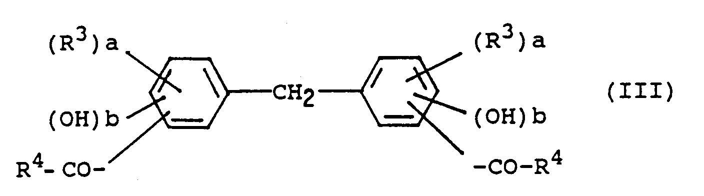
worin
R³ eine (C₁-C₄)Alkylgruppe,
R⁴ ein Wasserstoffatom, eine (C₁-C₄)Alkyl- oder Phenylgruppe und
a, b die oben angegebene Bedeutung haben.

3. Aufzeichnungsmaterial gemäß Anspruch 1 oder 2, dadurch gekennzeichnet, daß das phenolische Additiv einen Hydroxygruppengehalt von 7 bis 19 mmol/g aufweist.

4. Aufzeichnungsmaterial gemäß einem oder mehreren der Ansprüche 1 bis 3, dadurch gekennzeichnet, daß das strahlungsempfindliche 1,2-Naphthochinon-2-diazid ein Ester aus 1,2-Naphthochinon-2-diazid-4- oder -5-sulfonsäure und einer phenolischen Verbindung mit mindestens 3 phenolischen Hydroxygruppen ist.

5. Aufzeichnungsmaterial gemäß einem oder mehreren der Ansprüche 1 bis 4, dadurch gekennzeichnet, daß die strahlungsempfindliche Verbindung mindestens 1 mmol/g Hydroxygruppen und mindestens 2 mmol/g Diazogruppen aufweisen.

6. Aufzeichnungsmaterial gemäß einem oder mehreren der Ansprüche 1 bis 5, dadurch gekennzeichnet, daß der Anteil des phenolischen Additivs etwa 1 bis 20 Gew.-%, bevorzugt 2 bis 10 Gew.-%, jeweils bezogen auf das Gesamtgewicht der nichtflüchtigen Bestandteile der strahlungsempfindlichen Schicht, beträgt.

7. Aufzeichnungsmaterial gemäß einem oder mehreren der Ansprüche 1 bis 6, dadurch gekennzeichnet, daß der Anteil der strahlungsempfindlichen Verbindungen 5 bis 50 Gew.-%, bevorzugt 10 bis 30 Gew.-%, jeweils bezogen auf das Gesamtgewicht der nichtflüchtigen Bestandteile der strahlungsempfindlichen Schicht, beträgt.

8. Aufzeichnungsmaterial gemäß einem oder mehreren der Ansprüche 1 bis 7, dadurch gekennzeichnet, daß das Novolak-Bindemittel einen Hydroxygruppengehalt von ≥ 7 mmol/g aufweist.

9. Aufzeichnungsmaterial gemäß einem oder mehreren der Ansprüche 1 bis 8, dadurch gekennzeichnet, daß der Anteil des Novolak-Bindemittels 40 bis 90 Gew.-%, bevorzugt 60 bis 85 Gew.-%, jeweils bezogen auf das Gesamtgewicht der nichtflüchtigen Bestandteile der strahlungsempfindlichen Schicht, beträgt.

10. Aufzeichnungsmaterial gemäß einem oder mehreren der Ansprüche 1 bis 9, dadurch gekennzeichnet, daß die strahlungsempfindliche Schicht einen Indikatorfarbstoff enthält.

11. Aufzeichnungsmaterial gemäß Anspruch 10, dadurch gekennzeichnet, daß der Indikatorfarbstoff ein kationischer Triarylmethan- oder Methinfarbstoff ist.

12. Aufzeichnungsmaterial gemäß Anspruch 10 oder 11, dadurch gekennzeichnet, daß der Anteil des Farbstoffs 0,1 bis 5 Gew.-%, bevorzugt 0,5 bis 3 Gew.-%, jeweils bezogen auf das Gesamtgewicht der nichtflüchtigen Bestandteile der strahlungsempfindlichen Schicht, beträgt.

13. Aufzeichnungsmaterial gemäß einem oder mehreren der Ansprüche 1 bis 8, dadurch gekennzeichnet, daß die mattierte Schicht Erhebungen mit einer mittleren Höhe von 0,5 bis 8,0 µm aufweist.

## Claims

1. A recording material which acts as a positive, comprising an aluminium support which is suitable for flat printing plates and a matt-finish radiation-sensitive layer which contains a 1,2-naphthoquinone-2-diazide as a radiation-sensitive compound and a binder which is insoluble in water but which is soluble or capable of swelling in aqueous alkali, characterised in that
- the radiation-sensitive 1,2-naphthoquinone-2-diazide is an ester of 1,2-naphthoquinone-2-diazide-4- or -5-sulphonic acid and a phenolic compound comprising at least 2 phenolic hydroxy groups, which has a content of phenolic hydroxy groups of at least 0.5 mmol/g and a content of diazo units of at least 1.5 mmol/g,
- the binder is a phenol/formaldehyde novolac comprising at least 5 mmol/g of phenolic hydroxy groups, the phenol component of which contains at least 30 mol-% of m-cresol and at least 10 mol-% of at least one xylenol and which has a weight average molecular weight M_{w} of 2000 to 12,000, and
- the radiation-sensitive layer additionally contains at least one phenolic additive which has a maximum molecular weight M_{w} of 600 and which comprises 2 to 4 non-condensed phenyl nuclei and at least 6 mmol/g of phenolic hydroxy groups.

2. A recording material according to claim 1, characterised in that the phenolic additive is a compound of formulae I to III: 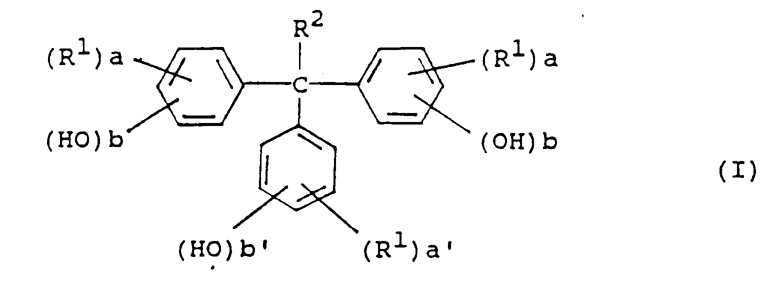 wherein
R¹ is a (C₁-C₄) alkyl, methoxy or ethoxy group,
R² is a hydrogen atom or a methyl group.
a, a' independently of each other, denote 0, 1 or 2, and
b, b' independently of each other, denote 1, 2 or 3; 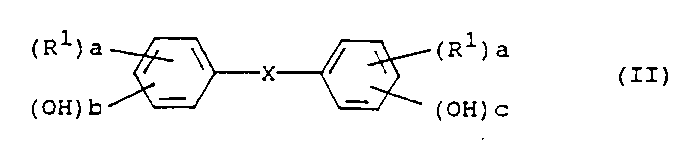
wherein
X denotes a single bond, SO₂, S, O or CO,
R¹, a, b have the meanings given above, and
c is an integer from 0 to 3: 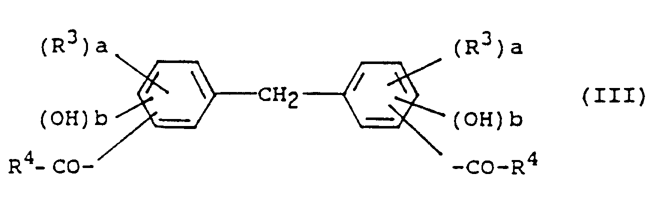
wherein
R denotes a (C₁-C₄) alkyl group,
R⁴ denotes a hydrogen atom, a (C₁-C₄) alkyl or a phenyl group, and
a, b have the meanings given above.

3. A recording material according to claims 1 or 2, characterised in that the phenolic additive has a hydroxy group content of 7 to 19 mmol/g.

4. A recording material according to one or more of claims 1 to 3, characterised in that the radiation-sensitive 1,2-naphthoquinone-2-diazide is an ester of 1,2-naphthoquinone-2-diazide-4- or -5-sulphonic acid and a phenolic compound comprising at least 3 phenolic hydroxy groups.

5. A recording material according to one or more of claims 1 to 4, characterised in that the radiation-sensitive compound comprises at least 1 mmol/g hydroxy groups and at least 2 mmol/g diazo groups.

6. A recording material according to one or more of claims 1 to 5, characterised in that the content of phenolic additive is about 1 to 20 % by weight, preferably 2 to 10 % by weight, with respect in each case to the total weight of the nonvolatile constituents of the radiation-sensitive layer.

7. A recording material according to one or more of claims 1 to 6, characterised in that the content of radiation-sensitive compounds is 5 to 50 % by weight, preferably 10 to 30 % by weight, with respect in each case to the total weight of the nonvolatile constituents of the radiation-sensitive layer.

8. A recording material according to one or more of claims 1 to 7, characterised in that the novolac binder has a hydroxy group content of ≥ 7 mmol/g.

9. A recording material according to one or more of claims 1 to 8, characterised in that the content of novolac binder is 40 to 90 % by weight, preferably 60 to 85 % by weight, with respect in each case to the total weight of the nonvolatile constituents of the radiation-sensitive layer.

10. A recording material according to one or more of claims 1 to 9, characterised in that the radiation-sensitive layer contains an indicator dye.

11. A recording material according to claim 10, characterised in that the indicator dye is a cationic triarylmethane or methine dye.

12. A recording material according to claims 10 or 11, characterised in that the content of dye is 0.1 to 5 % by weight, preferably 0.5 to 3 % by weight, with respect in each case to the total weight of the nonvolatile constituents of the radiation-sensitive layer.

13. A recording material according to one or more of claims 1 to 8, characterised in that the matt-finish layer comprises elevations with an average height of 0.5 to 8.0 µm.

## Revendications

1. Matériau d'enregistrement positif comportant un support en aluminium approprié aux plaques d'impression à plat et une couche sensible aux rayonnements rendue mate qui contient un 1,2-naphtoquinone-2-diazide comme composé sensible aux rayonnements et un liant insoluble dans l'eau mais soluble ou gonflable dans un alcali aqueux, caractérisé en ce que
- le 1,2-naphtoquinone-2-diazide sensible aux rayonnements est un ester de l'acide 1,2-naphtoquinone-2-diazide-4- ou -5-sulfonique et d'un composé phénolique ayant au moins 2 groupes hydroxyle phénoliques, qui a une teneur en groupes hydroxyle phénoliques d'au moins 0,5 mmol/g et une teneur en unités diazo d'au moins 1,5 mmol/g,
- le liant est une novolaque phénol/formaldéhyde ayant au moins 5 mmol/g de groupes hydroxyle phénoliques dont le composant phénol contient au moins 30 mol % de m-crésol et au moins 10 mol % d'au moins un xylénol, et a une masse moléculaire moyenne Mₚ de 2 000 à 12 000 et
- la couche sensible aux rayonnements contient en outre au moins un additif phénolique qui a une masse moléculaire Mₚ d'au maximum 600 ainsi que 2 à 4 noyaux phényle non condensés et au moins 6 mmol/g de groupes hydroxyle phénoliques.

2. Matériau d'enregistrement selon la revendication 1, caractérisé en ce que l'additif phénolique est un composé des formules I à III : 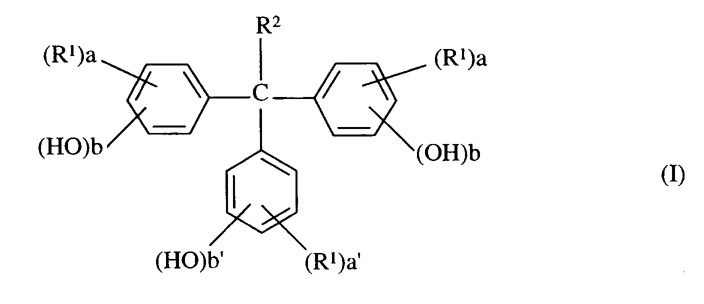 où
R¹ est un groupe alkyle en C₁-C₄, méthoxy ou éthoxy,
R² est un atome d'hydrogène ou un groupe méthyle,
a, a' sont indépendamment l'un de l'autre 0, 1 ou 2, et
b, b' sont indépendamment l'un de l'autre 1, 2 ou 3; 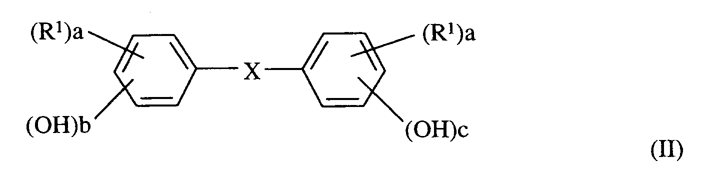
où
X représente une simple liaison, SO₂, S, O ou CO
R¹, a, b ont la signification indiquée ci-dessus et
c est un nombre entier de 0 à 3; 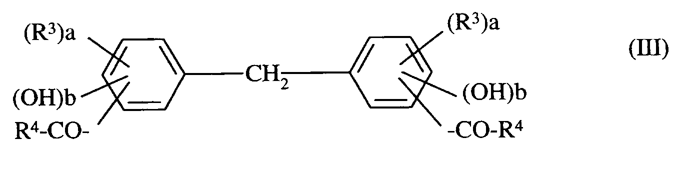
où
R³ est un groupe alkyle en C₁-C₄,
R⁴ est un atome d'hydrogène, un groupe alkyle en C₁-C₄ ou un groupe phényle et
a, b ont la signification indiquée ci-dessus.

3. Matériau d'enregistrement selon la revendication 1 ou 2, caractérisé en ce que l'additif phénolique présente une teneur en groupes hydroxyle de 7 à 19 mmol/g.

4. Matériau d'enregistrement selon une ou plusieurs des revendications 1 à 3, caractérisé en ce que le 1,2-naphtoquinone-2-diazide sensible aux rayonnements est un ester d'acide 1,2-naphtoquinone-2-diazide-4- ou -5-sulfonique et d'un composé phénolique ayant au moins trois groupes hydroxyle phénoliques.

5. Matériau d'enregistrement selon une ou plusieurs des revendications 1 à 4, caractérisé en ce que le composé sensible aux rayonnements comporte au moins 1 mmol/g de groupes hydroxyle et au moins 2 mmol/g de groupes diazo.

6. Matériau d'enregistrement selon une ou plusieurs des revendications 1 à 5, caractérisé en ce que la proportion de l'additif phénolique est d'environ 1 à 20 % en masse, de préférence 2 à 10 % en masse, à chaque fois par rapport à la masse totale des constituants non volatils de la couche sensible aux rayonnements.

7. Matériau d'enregistrement selon une ou plusieurs des revendications 1 à 6, caractérisé en ce que la proportion des composés sensibles aux rayonnements est de 5 à 50 % en masse, de préférence de 10 à 30 % en masse, à chaque fois par rapport à la masse totale des constituants non volatils de la couche sensible aux rayonnements.

8. Matériau d'enregistrement selon une ou plusieurs des revendications 1 à 7, caractérisé en ce que le liant novolaque présente une teneur en groupes hydroxyle ≥ 7 mmol/g.

9. Matériau d'enregistrement selon une ou plusieurs des revendications 1 à 8, caractérisé en ce que la proportion du liant novolaque est de 40 à 90 % en masse, de préférence de 60 à 85 % en masse, à chaque fois par rapport à la masse totale des constituants non volatils de la couche sensible aux rayonnements.

10. Matériau d'enregistrement selon une ou plusieurs des revendications 1 à 9, caractérisé en ce que la couche sensible aux rayonnements contient un colorant indicateur.

11. Matériau d'enregistrement selon la revendication 10, caractérisé en ce que le colorant indicateur est un colorant de triarylméthane ou méthinique cationique.

12. Matériau d'enregistrement selon la revendication 10 ou 11, caractérisé en ce que la proportion de colorant est de 0,1 à 5 % en masse, de préférence de 0,5 à 3 % en masse, à chaque fois par rapport à la masse totale des constituants non volatils de la couche sensible aux rayonnements.

13. Matériau d'enregistrement selon une ou plusieurs des revendications 1 à 8, caractérisé en ce que la couche rendue mate comporte des élévations ayant une hauteur moyenne de 0,5 à 8,0 µm.
